# FASCICULE DE BREVET EUROPEEN

(11) **EP 3 017 076 B1**
(45) Date de publication et mention de la délivrance du brevet: **06.05.2020**
(21) Numéro de dépôt: 14747128.8
(22) Date de dépôt: 04.07.2014
(51) Int. Cl.: C23C 2/02, C23C 2/06, C23C 2/26, C23C 14/02, C25D 11/34, C23C 14/16, C23C 14/58, C23C 22/60, C23C 22/68, C23C 28/00, C25D 3/56, C25D 5/48, C23C 22/53, C25D 7/06

(54) **PROCEDE DE TRAITEMENT D'UNE TOLE POUR REDUIRE SON NOIRCISSEMENT OU SON TERNISSEMENT LORS DE SON STOCKAGE ET TOLE TRAITEE PAR TEL PROCEDE**
METALLBLECHBEHANDLUNGSVERFAHREN ZUR REDUZIERUNG DER SCHWÄRZUNG ODER MATTIERUNG WÄHREND DER LAGERUNG DAVON UND MIT DIESEM VERFAHREN BEHANDELTES METALLBLECH
SHEET METAL TREATMENT METHOD FOR REDUCING BLACKENING OR TARNISHING DURING THE STORAGE THEREOF, AND METAL SHEET TREATED WITH THIS METHOD

(30) Priorité: 04.07.2013 WO PCT/IB2013/001447
(43) Date de publication de la demande: 11.05.2016
(73) Titulaire: ArcelorMittal, 1160 Luxembourg (LU)
(72) Inventeur: CHALEIX, Daniel, 57420 Verny (FR); ALLELY, Christian, 57100 Metz (FR); MONNOYER, Maxime, 54560 Audun le Roman (FR); FELTIN, Pascale, 57855 Saint Privat la Montagne (FR)
(74) Mandataire: Lavoix
(86) Numéro de dépôt international: PCT/IB2014/001271
(87) Numéro de publication internationale: WO 2015/001419

(56) Documents cités:
- WO-A1-2008/102009
- SCHUERZ S ET AL: "Corrosion behaviour of Zn-Al-Mg coated steel sheet in sodium chloride-containing environment", CORROSION SCIENCE, OXFORD, GB, vol. 51, no. 10, 1 octobre 2009 (2009-10-01), pages 2355-2363, XP026565286, ISSN: 0010-938X, DOI: 10.1016/J.CORSCI.2009.06.019 [extrait le 2009-06-17]
- HOSKING ET AL: "Corrosion resistance of zinc-magnesium coated steel", CORROSION SCIENCE, OXFORD, GB, vol. 49, no. 9, 19 juillet 2007 (2007-07-19), pages 3669-3695, XP022158027, ISSN: 0010-938X, DOI: 10.1016/J.CORSCI.2007.03.032
- VOLOVITCH P ET AL: "Understanding corrosion via corrosion product characterization: I. Case study of the role of Mg alloying in Zn-Mg coating on steel", CORROSION SCIENCE, OXFORD, GB, vol. 51, no. 6, 1 juin 2009 (2009-06-01), pages 1251-1262, XP026138981, ISSN: 0010-938X, DOI: 10.1016/J.CORSCI.2009.03.005 [extrait le 2009-03-19]
- PROSEK T ET AL: "Corrosion mechanism of model zinc-magnesium alloys in atmospheric conditions", CORROSION SCIENCE, OXFORD, GB, vol. 50, no. 8, 1 août 2008 (2008-08-01), pages 2216-2231, XP025625859, ISSN: 0010-938X, DOI: 10.1016/J.CORSCI.2008.06.008 [extrait le 2008-06-15]

## Description

La présente invention est relative à une tôle comprenant un substrat en acier revêtu sur au moins une de ses faces par un revêtement métallique comprenant du zinc et du magnésium.

De telles tôles sont plus particulièrement destinées à la fabrication de pièces pour l'automobile, sans pour autant y être limitées.

Les revêtements métalliques comprenant essentiellement du zinc sont traditionnellement utilisés pour leur bonne protection contre la corrosion des aciers, que ce soit dans le domaine automobile ou dans la construction, par exemple. Cependant, ces revêtements sont à présent concurrencés par des revêtements plus performants comprenant du zinc, du magnésium et éventuellement de l'aluminium et désignés par la suite sous le terme de revêtements ZnMg(AI).

En effet, l'ajout de magnésium augmente nettement la résistance à la corrosion perforante de ces revêtements, ce qui peut permettre de réduire leur épaisseur ou bien encore de maintenir l'épaisseur de revêtement et d'augmenter la garantie de protection contre la corrosion dans le temps.

Des analyses des produits de corrosion formés sur des revêtements comprenant essentiellement du zinc en comparaison avec des revêtements ZnMg(AI) ont permis d'expliquer l'effet bénéfique du magnésium. Il ressort notamment de la publication « understanding corrosion via corrosion product characterization : II. Role of alloying elements in improving the corrosion résistance of Zn-Al-Mg coatings on steel », P. Volovitch et al, Corrosion Science 53 (2011) 2437-2445, que les revêtements ZnMg(AI) présentent en surface un mélange de produits de corrosion tels que la simonkolléite de formule Zn₅(OH)₈Cl₂, H₂O, l'hydrozincite de formule Zn₅(CO₃)₂(OH)₆, l'hydroxysulfate de zinc de formule Zn₄SO₄(OH)₆.xH₂O, des hydroxycarbonates mixtes de zinc et d'aluminium, tels que les LDH (layered double hydroxide) de formule ZnₓAl_{y}(CO₃)ₘ(OH)ₙ.zH₂O, lors de leur exposition à des atmosphères agressives. De plus, le produit de corrosion majoritairement formé au début de l'exposition des tôles revêtues à une atmosphère marine, à savoir la simonkolléite, est indirectement stabilisé par la présence d'ions Mg²⁺ issus de la dissolution partielle du revêtement métallique. En effet, les ions Mg²⁺ réagissent préférentiellement avec les carbonates, issus de la dissolution du CO₂ atmosphérique dans le milieu corrosif, évitant ainsi que ce ne soit la simonkolléite qui réagisse avec eux et se transforme en hydrozincite ou smithsonite, produits de corrosion présentant de moins bonnes propriétés barrière.

Il est également connu de la publication « Influence of Mg content in coating layer and coating structure on corrosion résistance of hot-dip Zn-Al-Mg alloy coated steel sheet », T. Tsujimura et al, Proceedings of the Galvatech '01, International Conférence on Zinc and Zinc Alloy Coated Steel, Brussels, Belgium, June 26-28, 2001, pp. 145-152 et de la publication « Properties of zinc alloy coated steel sheets obtained by continuous vapor déposition pilot-line », J. Kawafuku et al, Proceedings of the 5th Automotive Corr. & Prévention Conference, Michigan, United States, October 21-23, 1991, SAE paper no. 912272, Philadelphia, 1991, pp. 43-50 que, pour certaines compositions de revêtement ZnMg(AI), les échantillons de tôles revêtues exposés à un test de corrosion contenant du chlorure de sodium se corrodent en début de test par l'apparition d'un seul produit de corrosion, la simonkolléite, concomitamment au dépôt sur les échantillons de sel hydrosoluble de chlorure de sodium (inhérente au sel corrosif utilisé dans le test de corrosion). Cette présence de simonkolléite en tant que seul produit de corrosion semble contribuer à la meilleure résistance à la corrosion de ces revêtements ZnMg(AI) spécifiques.

Ainsi la connaissance de la nature des produits de corrosion se formant sur les revêtements exposés à divers milieux ambiants permet de guider l'industriel dans le choix des éléments à ajouter au zinc et de leurs proportions respectives de sorte à obtenir les revêtements les plus protecteurs.

Cependant, cette optimisation des revêtements ZnMg(AI) ne permet pas d'éviter une légère altération de surface résultant du stockage des bobines de tôles avec de tels revêtements en surface.

Le stockage des bobines de tôles avant utilisation par les clients est classique. Les bobines peuvent ainsi être amenées à séjourner plusieurs mois dans des hangars de stockage et y être soumises à de fortes variations de conditions atmosphériques. Au cours de ce séjour, la surface ne doit pas s'altérer et en particulier la corrosion ne doit pas se développer. A cet effet, les produits galvanisés standards, c'est-à-dire dont les revêtements comprennent essentiellement du zinc, sont enduits d'une huile de protection.

Il a cependant été observé que, lorsque les tôles ZnMg(AI) sont huilées avant bobinage comme les tôles galvanisées standard, une légère oxydation de surface qui modifie l'interaction de la lumière avec la surface et qui modifie de ce fait son aspect visuel peut se produire en cas de démouillage de l'huile de protection.

Pour les revêtements comprenant du zinc et du magnésium, des points noirs apparaissent dans les zones de démouillage. On parle alors de noircissement. Pour les revêtements comprenant du zinc, du magnésium et de l'aluminium, l'ensemble de la surface qui n'est plus recouvert d'huile se ternit. On parle alors de ternissement.

Par ailleurs, le recours à une huile de protection temporaire est assez contraignant car, d'une part, l'huile tend à salir l'environnement de travail et les outils utilisés pour découper et mettre en forme les bobines de tôles et, d'autre part, un dégraissage est souvent nécessaire dans une étape ultérieure de fabrication des pièces issues de ces bobines.

Il existe donc un besoin pour développer un système de protection temporaire pour de tels revêtements, notamment vis-à-vis des phénomènes de noircissement et de ternissement, système qui soit efficace même en l'absence d'huile de protection temporaire.

A cet effet, l'invention a pour premier objet un procédé de traitement d'une bande métallique 3 en défilement comprenant les étapes selon lesquelles :
- on approvisionne une bande 3 en acier revêtu sur au moins une de ses faces 5 d'un revêtement 7 comprenant de 0,1 à 20% en poids de magnésium, éventuellement de 0,1 à 20% en poids d'aluminium, le reste étant du zinc, des éventuelles impuretés liées au procédé et éventuellement un ou plusieurs éléments additionnels choisis parmi Si, Sb, Pb, Ti, Ca, Mn, Sn, La, Ce, Cr, Ni, Zr et Bi, la teneur en poids de chaque élément additionnel étant inférieure à 0,3%,
- on applique sur le revêtement 7, par simple mise en contact, une solution aqueuse de traitement comprenant au moins 0,01 mol/L de chlorure de zinc et ne comprenant ni chlorure de sodium ni chlorure de potassium, la concentration en ions chlorure Cl⁻ étant adaptée de sorte à former sur le revêtement 7 une couche 13 à base d'hydroxychlorure de zinc présentant un poids de couche en chlore d'au moins 1 mg/m², la couche 13 ne comprenant ni hydrozincite ni hydroxycarbonates mixtes de zinc et d'aluminium ; ladite température étant comprise entre 20 et 60°C et le temps de contact avec le revêtement étant compris entre 2 secondes et 2 minutes.

Le procédé selon l'invention peut également comprendre les caractéristiques suivantes prises isolément ou en combinaison :
- il comprend une étape supplémentaire de séchage postérieure à l'application de la solution aqueuse de traitement,
- la solution aqueuse de traitement comprend en outre des ions Mg²⁺ à une concentration comprise entre 5.10-5 et 0,25 mol/L,
- les ions Mg²⁺ sont ajoutés dans la solution aqueuse sous forme de chlorure de magnésium,
- la solution aqueuse de traitement ne comprend aucun sel de chlorure autre que chlorure de zinc et/ou chlorure de magnésium.

L'invention a également pour deuxième objet un procédé de traitement d'une bande métallique 3 en défilement comprenant les étapes selon lesquelles :
- on approvisionne une bande 3 en acier revêtu sur au moins une de ses faces 5 d'un revêtement 7 comprenant de 0,1 à 20% en poids de magnésium, éventuellement de 0,1 à 20% en poids d'aluminium, le reste étant du zinc, des éventuelles impuretés liées au procédé et éventuellement un ou plusieurs éléments additionnels choisis parmi Si, Sb, Pb, Ti, Ca, Mn, Sn, La, Ce, Cr, Ni, Zr et Bi, la teneur en poids de chaque élément additionnel étant inférieure à 0,3%,
- on applique sous polarisation anodique sur le revêtement 7 une solution aqueuse de traitement de pH compris entre 7 et 10 comprenant au moins 0,01 mol/L d'ions chlorure Cl⁻ de sorte à former sur le revêtement 7 une couche 13 à base d'hydroxychlorure de zinc présentant un poids de couche en chlore d'au moins 1 mg/m², la couche 13 ne comprenant ni hydrozincite ni hydroxycarbonates mixtes de zinc et d'aluminium, ladite quantité de charge étant comprise entre 10 et 100C/dm2,
- on rince la surface traitée.

Ce procédé selon l'invention peut également comprendre une étape supplémentaire de séchage postérieure au rinçage.

L'invention a également pour troisième objet une tôle 1 comprenant un substrat 3 en acier revêtu sur au moins une de ses faces 5 d'un revêtement 7 comprenant de 0,1 à 20% en poids de magnésium, éventuellement de 0,1 à 20% en poids d'aluminium, le reste étant du zinc, des éventuelles impuretés liées au procédé et éventuellement un ou plusieurs éléments additionnels choisis parmi Si, Sb, Pb, Ti, Ca, Mn, Sn, La, Ce, Cr, Ni, Zr et Bi, la teneur en poids de chaque élément additionnel étant inférieure à 0,3%, le revêtement 7 étant lui-même recouvert d'une couche 13 à base d'hydroxychlorure de zinc présentant un poids de couche en chlore d'au moins 1 mg/m², la couche 13 ne comprenant ni hydrozincite ni hydroxycarbonates mixtes de zinc et d'aluminium, ni composés hydrosolubles de sodium ou de potassium.

La tôle selon l'invention peut également comprendre les caractéristiques suivantes prises isolément ou en combinaison :
- le revêtement 7 comprend en outre de l'aluminium pour une teneur en poids comprise entre 0,1 et 20%,
- le revêtement 7 comprend entre 14 et 18% en poids de magnésium, le reste étant du zinc,
- le poids de couche en chlore est inférieur à 70 mg/m²,
- le poids de couche en chlore est compris entre 8 et 60 mg/m²,
- la couche 13 présente une répartition homogène sur l'ensemble de la surface du revêtement 7,
- la couche 13 ne comprend en outre aucun composé hydrosoluble de calcium,
- la couche 13 ne comprend aucun composé hydrosoluble autre que de zinc et/ou de magnésium.

D'autres caractéristiques et avantages de l'invention apparaîtront à la lecture de la description qui va suivre, donnée uniquement à titre d'exemple non limitatif.

L'invention va à présent être illustrée par des exemples donnés à titre indicatif, et non limitatif, et en référence aux figures annexées sur lesquelles :
- la figure 1 est une vue schématique en coupe illustrant la structure d'une tôle selon l'invention,
- la figure 2 présente des courbes illustrant les résultats de tests de vieillissement en exposition naturelle sous abri effectués sur différentes éprouvettes de tôle traitées avec une première solution selon l'invention ou non traitées,
- la figure 3 présente des courbes illustrant les résultats de tests de vieillissement en exposition naturelle sous abri effectués sur différentes éprouvettes de tôle traitées avec une deuxième solution selon l'invention ou non traitées.

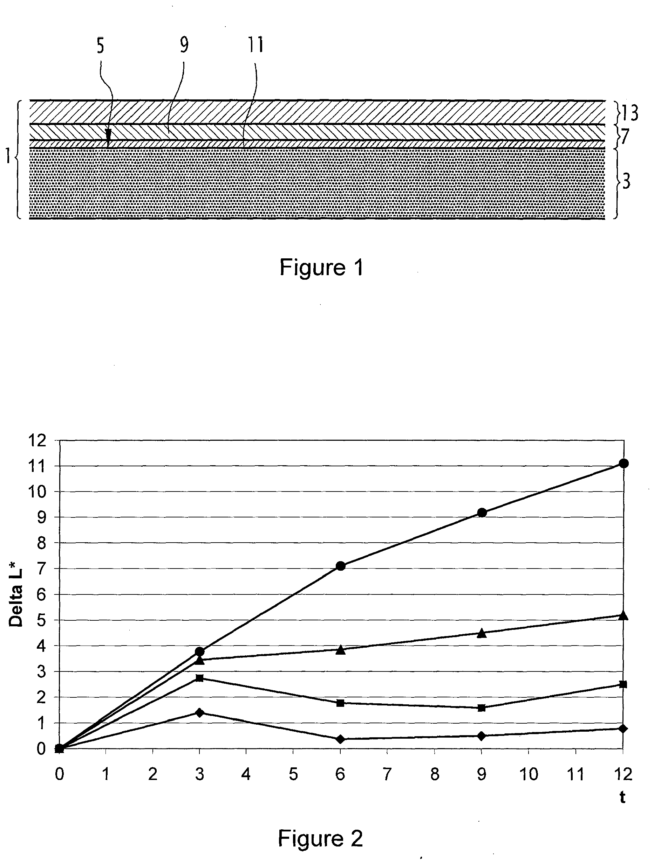

La tôle 1 de la figure 1 comprend un substrat 3 en acier, de préférence laminé à chaud puis laminé à froid. Le substrat 3 est recouvert sur une face 5 par un revêtement 7, lui-même recouvert d'une couche 13 de protection temporaire. Bien que la figure 1 ne représente le revêtement 7 et la couche 13 de protection temporaire que sur une face du substrat, il va de soi que ceux-ci peuvent être présents sur les deux faces du substrat. On observera que les épaisseurs relatives du substrat 3 et des différentes couches le recouvrant n'ont pas été respectées sur la figure 1 afin de faciliter la représentation.

La tôle 1 et le substrat 3 peuvent être tant sous la forme d'une bande, bobinée ou non, que sous la forme d'un échantillon par exemple prélevé sur la bande par découpage, poinçonnage ou tout autre technique adaptée.

Tout d'abord, le revêtement 7 comprend au moins une couche 9 comprenant au moins du zinc et du magnésium. De préférence, la couche 9 comprend de 0,1 à 20% en poids de magnésium, éventuellement de 0,1 à 20% en poids d'aluminium, le reste étant du zinc, des éventuelles impuretés liées au procédé et éventuellement un ou plusieurs éléments additionnels choisis parmi Si, Sb, Pb, Ti, Ca, Mn, Sn, La, Ce, Cr, Ni, Zr et Bi, la teneur en poids de chaque élément additionnel étant inférieure à 0,3%.

De préférence, la couche 9 est constituée de 0,1 à 20% en poids de magnésium, le reste étant du zinc et au moins un élément à choisir parmi 0,1 à 20% en poids d'aluminium, les impuretés liées au procédé et les éléments additionnels choisis parmi Si, Sb, Pb, Ti, Ca, Mn, Sn, La, Ce, Cr, Ni, Zr et Bi, la teneur en poids de chaque élément additionnel étant inférieure à 0,3%.

Concernant le magnésium, en deçà de 0,1%, aucun effet de protection contre la corrosion perforante n'est visible. Au delà de 20%, en revanche, la proportion plus importante de magnésium entraînerait une consommation trop rapide du revêtement 7 et donc des performances anticorrosion paradoxalement dégradées.

Dans un mode de réalisation préféré, la couche 9 contient au moins 0,5% en poids de magnésium, de préférence au moins 2%.

Cette couche 9 présente généralement une épaisseur inférieure ou égale à 20 µm et vise à protéger le substrat 3 contre la corrosion perforante.

Tout moyen adapté peut être utilisé pour former la couche 9.

Selon un premier mode de réalisation, la couche 9 est obtenue par un procédé de dépôt sous vide, tel que le sputtering magnétron, ou l'évaporation sous vide par effet joule, par induction ou sous faisceau d'électrons.

Dans ce cas, la couche 9 ne comprend généralement que du zinc et du magnésium, d'autres éléments, tels que l'aluminium ou le silicium pouvant cependant être ajoutés, si nécessaire, pour améliorer d'autres caractéristiques de la couche 9 telles que sa ductilité ou son adhésion au substrat 3.

Lorsque la couche 9 ne comprend que du zinc et du magnésium, on préfère en particulier que la couche 9 comprenne entre 14 et 18% en poids de magnésium, et mieux qu'elle corresponde majoritairement au composé intermétallique de formule Zn₂Mg, comportant environ 16% en poids de magnésium, qui présente une très bonne résistance à la corrosion perforante.

Dans une variante de ce mode de réalisation, on peut simplement déposer sous vide du magnésium sur du zinc préalablement déposé par électrodéposition sur le substrat 3 et réaliser ensuite un traitement thermique pour allier le magnésium et le zinc de sorte à former la couche 9 comprenant du zinc et du magnésium. Dans ce cas, après traitement thermique et en fonction de celui-ci, une partie du zinc préalablement déposé par électrodéposition peut être encore présente sous la forme d'une couche 11 de zinc située entre la face 5 du substrat et la couche 9.

Selon un second mode de réalisation, la couche 9 peut être obtenue par un procédé de revêtement au trempé à chaud dans un bain de zinc fondu contenant du magnésium jusqu'à une teneur de 10% en poids et de l'aluminium jusqu'à une teneur de 20% en poids. Le bain peut également contenir jusqu'à 0,3% en poids d'éléments optionnels d'addition tels que Si, Sb, Pb, Ti, Ca, Mn, Sn, La, Ce, Cr, Ni, Zr ou Bi.

Ces différents éléments peuvent permettre, entre autres, d'améliorer la ductilité ou l'adhésion de la couche 9 sur le substrat 3. L'homme du métier qui connaît leurs effets sur les caractéristiques de la couche 9 saura les employer en fonction du but complémentaire recherché.

Le bain peut enfin contenir des éléments résiduels provenant des lingots d'alimentation ou résultant du passage du substrat 3 dans le bain, tels que du fer à une teneur allant jusqu'à 0,5% en poids et généralement comprise entre 0,1 et 0,4% en poids. Ces éléments résiduels sont pour partie incorporés dans la couche 9 et sont alors désignés sous le terme d'impuretés.

De préférence, la couche 9 de ce mode de réalisation comprend entre 0,1 et 10% en poids de magnésium et entre 0,1 et 20% en poids d'aluminium. De préférence encore, la couche 9 comprend entre 2 et 4% en poids de magnésium et entre 2 et 6% en poids d'aluminium ; la composition est alors proche de celle de l'eutectique ternaire zinc/aluminium/magnésium.

Toujours à l'appui de la figure 1, le revêtement 7 est recouvert d'une couche 13 de protection temporaire à base de simonkolléite (Zn₅(OH)₈Cl₂, H₂O), autrement dénommée hydroxychlorure de zinc.

Comme on le verra dans les exemples ultérieurs, les inventeurs ont montré que la présence d'une couche 13 permettait d'améliorer la résistance au noircissement dans le cas d'un revêtement 7 comprenant du zinc et du magnésium, et d'améliorer la résistance au ternissement dans les cas où le revêtement 7 comprend du zinc, du magnésium et de l'aluminium. Cette résistance accrue est particulièrement utile en cas d'absence de film d'huile, par exemple suite à un démouillage d'un film d'huile appliqué sur le revêtement 7.

Cette augmentation de la résistance au noircissement et au ternissement est due essentiellement à la formation d'une couche de conversion à base de simonkolléite.

La couche 13 est obtenue par application sur le revêtement 7, éventuellement après dégraissage, d'une solution aqueuse de traitement comprenant des ions chlorures Cl⁻.

Les réactions mises en jeu lors de l'application de cette solution aqueuse sur le revêtement 7 sont:
1. Attaque acide du zinc métal, qui aboutit à la formation d'ions Zn²⁺ et à l'alcalinisation du milieu : Zn + 2H₂O -> Zn²⁺ + 2OH⁻ + H₂
2. Précipitation d'hydroxychlorure de zinc sous l'effet de l'accumulation d'ions Zn²⁺ et OH⁻ dans la solution de chlorure : 5 Zn²⁺ + 2 Cl⁻ + 8 OH⁻ -> Zn₅(OH)₈Cl₂

De ce fait, la couche 13 ne comprend ni hydrozincite (de formule Zn₅(CO₃)₂(OH)₆) ni hydroxycarbonates mixtes de zinc et d'aluminium, tels que les LDH (layered double hydroxide) de formule ZnₓAl_{y}(CO₃)ₘ(OH)ₙ.zH₂O, contrairement à ce que l'on observe sur des revêtements 7 exposés à une atmosphère saline.

Par ailleurs, la couche 13 ne comprend aucun composé hydrosoluble résiduel de sodium ou de potassium, en particulier aucun sel soluble résiduel de chlorure de sodium ou de chlorure de potassium. L'absence de ces composés hydrosolubles résiduels améliore la résistance au noircissement/ternissement et la résistance à la corrosion de la tôle 1. Leur absence est inhérente aux procédés selon l'invention comme cela sera détaillé plus tard.

De préférence, la couche 13 ne comprend aucun composé hydrosoluble résiduel de sodium, de potassium ou de calcium, en particulier aucun sel soluble résiduel de chlorure de sodium, de chlorure de potassium ou de chlorure de calcium. L'absence supplémentaire de composé hydrosoluble résiduel de calcium permet d'améliorer encore davantage la résistance au noircissement/ternissement et la résistance à la corrosion de la tôle 1. Son absence est inhérente à des variantes des procédés selon l'invention comme cela sera détaillé plus tard.

De préférence encore, la couche 13 ne comprend aucun composé hydrosoluble résiduel autre que de zinc et/ou de magnésium, en particulier aucun sel de chlorure résiduel autre que chlorure de zinc et/ou chlorure de magnésium. Leur absence permet d'améliorer encore davantage la résistance au noircissement/ternissement et la résistance à la corrosion de la tôle 1. Leur absence est inhérente à des variantes des procédés selon l'invention comme cela sera détaillé plus tard.

En terme de répartition surfacique, la couche 13 présente une répartition homogène sur l'ensemble de la surface du revêtement 7 contrairement à ce qui est observé sur un tel revêtement exposé à une atmosphère saline pour lequel le développement des produits de corrosion se fait de façon aléatoire au gré des défauts de surface et de la présence des chlorures. On entend par répartition homogène le fait qu'une analyse par spectroscopie de fluorescence X, au moyen d'un appareil présentant une fenêtre de l'ordre de 1 cm², en un point quelconque de la surface, révèle la présence de la couche 13. L'homogénéité de la couche 13 est inhérente au fait que le revêtement 7 est exposé dans son ensemble à une solution aqueuse de traitement.

Le poids de couche de la couche 13 est exprimé par la mesure du poids de couche en chlore. Ce dernier est supérieur ou égal à 1 mg/m² car en-dessous de 1 mg/m² le pouvoir couvrant de la couche 13 ainsi formée n'est pas suffisant pour garantir l'absence de noircissement/ternissement lors du stockage.

De préférence, le poids de couche en chlore est inférieur ou égal à 70 mg/m². En effet, les bonnes performances obtenues avec des poids de couche inférieurs à 70mg/m² ne justifient pas qu'on accroisse encore davantage le poids de couche.

De façon plus préférentielle, le poids de couche en chlore est compris entre 8 et 60 mg/m².

La solution aqueuse de traitement comprend des ions chlorures Cl⁻ à une concentration supérieure ou égale à 0,01 mol/L. Ces ions chlorures peuvent être issus notamment du chlorure de zinc, du chlorure de sodium, du chlorure de potassium ou encore du chlorure de calcium, donnés à titre d'exemples non limitatifs.

Lorsqu'on utilise du chlorure de sodium dans la solution aqueuse de traitement, si la concentration en chlorure de sodium est inférieure à 0,58 g/L dans la solution, on observe peu de formation d'hydroxychlorure de zinc sur la surface. Cette concentration équivaut à 0,01 mol/L de Cl⁻ et, de façon plus générale, il importe donc que la concentration en ions Cl⁻ soit supérieure ou égale à 0,01 mol/L, et de préférence supérieure ou égale à 0,07 mol/L.

En outre, la concentration en ions chlorures est préférentiellement inférieure ou égale à 1 mole/L. En effet, dans le cas de l'utilisation de chlorure de sodium, à des concentrations supérieures à 58 g/L, on observe une diminution du rendement de formation de la couche 13.

Dans un mode de réalisation préféré, la solution aqueuse de traitement comprend en outre des ions Zn²⁺ à une concentration supérieure ou égale à 0,005 mol/L, lesquels permettent d'obtenir un dépôt plus homogène. Dans ce cas, la solution aqueuse de traitement est préparée par exemple par dissolution de chlorure de zinc dans de l'eau pure.

Dans un mode de réalisation préféré, la solution aqueuse de traitement comprend en outre des ions Mg²⁺. Comme indiqué plus haut, ces ions contribuent à la meilleure stabilisation de la couche d'hydroxychlorure de zinc formée en réagissant avec les carbonates en lieu et place de la simonkolléite. L'ajout d'ions Mg²⁺ dans la solution aqueuse de traitement en complément des ions Mg²⁺ issus de la dissolution partielle du revêtement 7 permet de différer encore davantage le risque de carbonatation de la couche 13 lors du stockage de la tôle traitée. De préférence, les ions Mg²⁺ sont ajoutés dans la solution aqueuse sous forme de sulfate de magnésium ou de chlorure de magnésium. De préférence, la concentration des ions Mg²⁺ est comprise entre 5.10⁻⁵ et 0,25 mol/L. En cas de recours à une solution de sulfate de magnésium, l'ajout d'ions Mg²⁺ se fera de préférence de telle sorte que le rapport molaire Mg²⁺/Cl⁻ soit inférieur à 10% de sorte à limiter la formation d'hydroxysulfate de zinc.

En cas de recours à une solution de chlorure de zinc, l'ajout d'ions Mg²⁺ se fera de préférence de telle sorte que le rapport molaire Mg²⁺/Zn²⁺ soit proche du rapport molaire Mg/Zn du revêtement 7. Il a en effet été constaté que le choix d'un tel rapport molaire favorisait la stabilisation de la couche 13.

Dans un mode de réalisation préféré, la solution aqueuse de traitement ne comprend aucun sel de chlorure autre que chlorure de zinc et/ou chlorure de magnésium. A titre d'exemple non limitatif, la solution aqueuse ne comprend ni chlorure d'aluminium, ni chlorure de calcium, ni chlorure de manganèse, ni chlorure de fer, ni chlorure de cobalt, ni chlorure de nickel, ni chlorure de cuivre, ni chlorure d'étain. L'absence des sels de chlorure autre que chlorure de zinc et/ou chlorure de magnésium permet d'éviter la présence de sodium, potassium, calcium et autres cations, qui forment des composés hydrosolubles résiduels dans la couche 13 et altèrent en conséquence la résistance au noircissement/ternissement et la résistance à la corrosion de la tôle 1.

De préférence, la solution aqueuse de traitement est appliquée en sortie de ligne de galvanisation ou de dépôt sous vide avant que d'éventuels oxydes de surface ne se développent et viennent modifier la réactivité de la surface du revêtement 7.

Selon un premier mode de réalisation de la couche 13, la solution aqueuse de traitement s'applique par simple mise en contact de celle-ci avec le revêtement 7, par exemple au trempé, par aspersion ou par enduction. De préférence, la solution aqueuse de traitement est appliquée sur la surface du revêtement 7 sous la forme d'un film liquide. Dans ce cas, c'est dans ce film liquide qu'ont lieu les réactions 1) et 2) détaillées précédemment.

Selon ce premier mode, le pH de la solution aqueuse de traitement correspond alors de préférence au pH naturel de la solution, sans addition de base ni d'acide, soit généralement entre 4 et 7.

De préférence, on applique la solution aqueuse de traitement sur le revêtement 7, dans des conditions de température, de temps de contact avec le revêtement 7, de concentration en ions Cl⁻ ajustées pour que la couche 13 présente un poids de couche en chlore supérieur ou égal à 1 mg/m².

Ainsi, la température de la solution aqueuse de traitement est comprise entre 20 et 60°C et le temps de contact de la solution aqueuse de traitement avec le revêtement 7 est compris entre 2 secondes et 2 minutes.

Avantageusement, la solution aqueuse de traitement est appliquée dans des conditions de température, de temps de contact avec le revêtement 7, et de concentrations en ions Cl⁻ ajustées pour former une couche 13 présentant un poids de couche en chlore compris entre 8 et 60 mg/m².

De préférence, la solution aqueuse de traitement utilisée pour ce premier mode de réalisation comprend du chlorure de zinc. Le choix du zinc en tant que cation permet d'éviter la présence de sodium ou de potassium susceptibles de former des composés hydrosolubles dans la couche d'hydroxychlorure de zinc. De préférence, la solution aqueuse de traitement contient entre 10 et 80 g/L de chlorure de zinc ZnCl₂, correspondant à une concentration en ions Cl⁻ comprise entre 0,14 et 1,2 mol/L. En effet, il a été constaté que, dans ce domaine de concentrations, la vitesse de dépôt était peu influencée par la valeur de la concentration.

De préférence, la solution aqueuse de traitement utilisée pour ce premier mode de réalisation ne comprend aucun sel de chlorure autre que chlorure de zinc et/ou chlorure de magnésium. L'absence des sels de chlorure autre que chlorure de zinc et/ou chlorure de magnésium permet d'éviter la présence de sodium, potassium, calcium et autres cations, qui forment des composés hydrosolubles résiduels dans la couche d'hydroxychlorure de zinc et altèrent en conséquence la résistance au noircissement/ternissement et la résistance à la corrosion de la tôle 1. Ainsi la couche 13 formée ne comprend notamment pas de composés hydrosolubles résiduels de chlorure de sodium contrairement à ce que l'on observe sur des revêtements 7 exposés à une atmosphère corrosive en milieu naturel ou en test accéléré.

Selon une variante de ce mode de réalisation, la solution aqueuse de traitement contient un agent oxydant du zinc, comme l'eau oxygénée. Cet agent oxydant peut avoir un effet accélérateur très marqué à faible concentration. On a constaté que l'addition de seulement 0,03%, soit 8.10⁻³ mol/L d'eau oxygénée, ou de 2.10⁻⁴ mole/L de permanganate de potassium dans la solution permettait de doubler (approximativement) la vitesse de dépôt. On a constaté, au contraire, que des concentrations 100 fois supérieures ne permettaient plus d'obtenir cette amélioration de la vitesse de dépôt.

Après application de la solution aqueuse de traitement et avant séchage, la couche 13 déposée est adhérente. Le séchage est ajusté pour éliminer l'eau résiduelle du dépôt.

Entre l'étape d'application et l'étape de séchage, on rince de préférence la tôle 1 de manière à éliminer la partie soluble du dépôt obtenu. L'absence de rinçage et l'obtention d'un dépôt partiellement solubilisable à l'eau qui en résulte ne sont pas très préjudiciables à la résistance à la corrosion au stockage, du moment que le dépôt obtenu comprend bien une couche 13 insoluble à l'eau (ce que permet la simonkolléite) et ne comprend pas de composé hydrosoluble résiduel de sodium ou de potassium.

Selon un second mode de réalisation de la couche 13, la solution aqueuse de traitement est appliquée sur le revêtement 7 sous polarisation anodique.

Dans ce cas, le pH de la solution aqueuse de traitement est compris entre 7 et 10. Si le pH de la solution est inférieur à 7, il ne se forme pas d'hydroxychlorures adhérents sur la surface à traiter. Si le pH de la solution est supérieur 10, l'hydroxychlorure se re-dissout et/ou se décompose.

De préférence, on applique la solution aqueuse de traitement sur le revêtement 7 en ajustant la quantité de charges électriques circulant pendant le traitement pour que la couche 13 présente un poids de couche en chlore supérieur ou égal à 1 mg/m².

La densité de charge appliquée est comprise entre 10 et 100 C/dm² de surface à traiter.

De préférence, il convient d'effectuer le dépôt de la couche 13 sous une densité de courant de polarisation élevée, notamment supérieure à 20 A/dm² et, par exemple de 200 A/dm².

Comme contre-électrode, on peut utiliser une cathode en titane.

La température de la solution aqueuse de traitement est généralement comprise entre 20°C et 60°C. De préférence, on procède à une température supérieure ou égale à 40°C, de manière à augmenter la conductivité de la solution et à diminuer les pertes ohmiques.

Après formation de la couche 13 selon cet autre mode de réalisation, on rince abondamment la surface traitée à l'eau déminéralisée. Cette étape de rinçage permet d'éliminer les réactifs alcalins à la surface du dépôt, qui causeraient des problèmes de corrosion. Ce rinçage permet également d'éliminer de la couche 13 les éventuels sels hydrosolubles résiduels de calcium, de potassium, ou de tout autre cation associé aux ions chlorures dans la composition de la solution aqueuse de traitement. Ce rinçage permet ainsi que, selon ce second mode de réalisation, la nature du ou des sel(s) de chlorure utilisé(s) dans la solution de traitement ne soit pas limitative.

Dans le cadre de ces deux modes de réalisation de la couche 13, l'application de la solution aqueuse de traitement sur le revêtement 7 s'effectue de préférence alors que le substrat 3 revêtu du revêtement 7 est en défilement sous la forme d'une bande. En particulier, l'application est faite en sortie de ligne de galvanisation ou en sortie de ligne de dépôt sous vide, de préférence entre l'étape de skin-pass et le bobinage. La mise en œuvre du procédé de traitement sur une bande métallique en défilement présente l'avantage de protéger le revêtement 7 dès sa fabrication et avant qu'il ne soit exposé à divers milieux ambiants.

Après réalisation de la couche 13 selon l'un des modes de réalisation décrits ci-dessus, on peut éventuellement lubrifier la couche 13 de la tôle 1.

Cette lubrification peut être assurée en appliquant sur la couche 13 un film d'huile (non-représenté) avec un poids de couche inférieur à 2 g/m².

Afin d'illustrer l'invention, des essais ont été réalisés et vont être décrits à titre d'exemples non limitatifs,

Des tôles d'acier laminé à froid d'une épaisseur de 0,7mm ont été préalablement revêtues par galvanisation au trempé d'un revêtement 7 d'environ 7 µm d'épaisseur et comprenant environ 3% en poids de magnésium et environ 3,7% en poids d'aluminium, le reste étant du zinc et les impuretés inévitables.

Deux solutions aqueuses de traitement ont été appliquées par enduction centrifuge à température ambiante sur les tôles revêtues. La première solution contenait 19,1g/L de chlorure de zinc ZnCl₂. La seconde contenait 19,1g/L de chlorure de zinc et 3g/L de sulfate de magnésium heptahydraté. A titre comparatif, une partie des tôles revêtues n'a pas été traitée.

Le temps de contact était d'environ 15 s. Le poids de couche en chlore obtenu était d'environ 42 mg/m², mesuré par spectroscopie de fluorescence X.

Une partie des tôles revêtues, traitées et non traitées, a enfin été huilée avec l'huile Quaker ® 6130 avec un poids de couche d'environ 1g/m².

La protection temporaire de ces tôles a été évaluée via un test de vieillissement en exposition naturelle sous abri selon la norme VDA 230-213 (durée du test 12 semaines). Il a en effet été constaté qu'un test en humidotherme ne permettait pas de reproduire le phénomène de ternissement observé dans des conditions naturelles de stockage.

Le suivi de l'évolution du ternissement au cours du test a été réalisé via un colorimètre mesurant l'écart de luminance (mesure du ΔL*). La valeur seuil de |ΔL*| correspondant à l'apparition du ternissement a été fixée à 3.

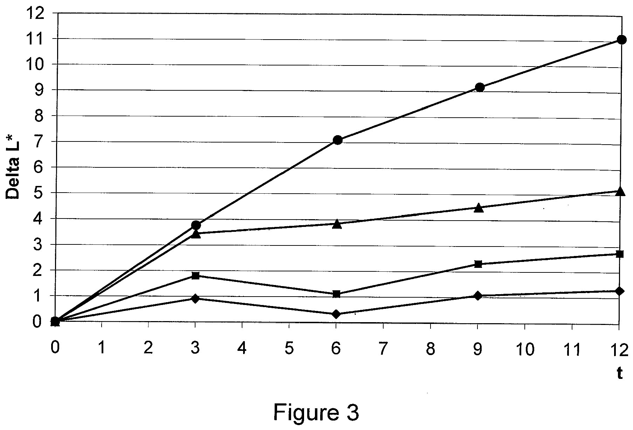

Les résultats obtenus respectivement avec la première solution de traitement et la deuxième solution de traitement sont représentés respectivement sur les figures 2 et 3 où le temps, en semaines, est porté en abscisses et l'évolution de ΔL* est portée en ordonnées.

Les différentes courbes sont repérées par les symboles suivants sur chacune des figures 2 et 3 :
● : tôle sans couche 13 ni huilage,
▲ : tôle sans couche 13 mais huilée,
■ : tôle avec couche 13 et huilée,
◆ : tôle avec couche 13 sans huilage.

Ces résultats montrent l'intérêt des couches 13 pour la protection temporaire contre le ternissement de revêtements 7 comprenant du zinc, du magnésium et de l'aluminium, puisque l'ensemble des tôles avec une couche 13 présentent une cinétique de ternissement ralentie par rapport aux tôles sans couche 13, que la couche 13 soit huilée ou non.

Bien que l'invention ait été présentée pour une utilisation dans le domaine de l'automobile, il va de soi qu'elle n'est pas limitée à ce domaine et qu'elle peut trouver un emploi pour toute pièce en acier quel que soit son usage final.

## Revendications

1. Procédé de traitement d'une bande métallique (3) en défilement comprenant les étapes selon lesquelles :
- on approvisionne une bande (3) en acier revêtu sur au moins une de ses faces (5) d'un revêtement (7) comprenant de 0,1 à 20% en poids de magnésium, éventuellement de 0,1 à 20% en poids d'aluminium, le reste étant du zinc, des éventuelles impuretés liées au procédé et éventuellement un ou plusieurs éléments additionnels choisis parmi Si, Sb, Pb, Ti, Ca, Mn, Sn, La, Ce, Cr, Ni, Zr et Bi, la teneur en poids de chaque élément additionnel étant inférieure à 0,3%,
- on applique sur le revêtement (7), par simple mise en contact, une solution aqueuse de traitement comprenant au moins 0,01 mol/L de chlorure de zinc et ne comprenant ni chlorure de sodium ni chlorure de potassium, la concentration en ions chlorure Cl⁻ étant adaptée de sorte à former sur le revêtement (7) une couche (13) à base d'hydroxychlorure de zinc présentant un poids de couche en chlore d'au moins 1 mg/m², la couche (13) ne comprenant ni hydrozincite ni hydroxycarbonates mixtes de zinc et d'aluminium; la température de la solution aqueuse étant comprise entre 20 et 60°C et le temps de contact avec le revêtement étant compris entre 2 secondes et 2 minutes.

2. Procédé selon la revendication 1 comprenant une étape supplémentaire de séchage postérieure à l'application de la solution aqueuse de traitement.

3. Procédé selon l'une quelconque des revendications 1 ou 2 pour lequel la solution aqueuse de traitement comprend en outre des ions Mg²⁺ à une concentration comprise entre 5.10⁻⁵ et 0,25 mol/L.

4. Procédé selon la revendication 3 pour lequel les ions Mg²⁺ sont ajoutés dans la solution aqueuse sous forme de chlorure de magnésium.

5. Procédé selon l'une quelconque des revendications 1 à 4 pour lequel la solution aqueuse de traitement ne comprend aucun sel de chlorure autre que chlorure de zinc et/ou chlorure de magnésium.

6. Procédé de traitement d'une bande métallique (3) en défilement comprenant les étapes selon lesquelles :
- on approvisionne une bande (3) en acier revêtu sur au moins une de ses faces (5) d'un revêtement (7) comprenant de 0,1 à 20% en poids de magnésium, éventuellement de 0,1 à 20% en poids d'aluminium, le reste étant du zinc, des éventuelles impuretés liées au procédé et éventuellement un ou plusieurs éléments additionnels choisis parmi Si, Sb, Pb, Ti, Ca, Mn, Sn, La, Ce, Cr, Ni, Zr et Bi, la teneur en poids de chaque élément additionnel étant inférieure à 0,3%,
- on applique sous polarisation anodique sur le revêtement (7) une solution aqueuse de traitement de pH compris entre 7 et 10 comprenant au moins 0,01 mol/L d'ions chlorure Cl⁻ de sorte à former sur le revêtement (7) une couche (13) à base d'hydroxychlorure de zinc présentant un poids de couche en chlore d'au moins 1 mg/m², la couche (13) ne comprenant ni hydrozincite ni hydroxycarbonates mixtes de zinc et d'aluminium, ladite quantité de charge étant comprise entre 10 et 100C/dm²,
- on rince la surface traitée.

7. Procédé selon la revendication 6 comprenant une étape supplémentaire de séchage postérieure au rinçage.

8. Tôle (1) comprenant un substrat (3) en acier revêtu sur au moins une de ses faces (5) d'un revêtement (7) comprenant de 0,1 à 20% en poids de magnésium, éventuellement de 0,1 à 20% en poids d'aluminium, le reste étant du zinc, des éventuelles impuretés liées au procédé et éventuellement un ou plusieurs éléments additionnels choisis parmi Si, Sb, Pb, Ti, Ca, Mn, Sn, La, Ce, Cr, Ni, Zr et Bi, la teneur en poids de chaque élément additionnel étant inférieure à 0,3%, le revêtement (7) étant lui-même recouvert d'une couche (13) à base d'hydroxychlorure de zinc présentant un poids de couche en chlore d'au moins 1 mg/m², la couche (13) ne comprenant ni hydrozincite ni hydroxycarbonates mixtes de zinc et d'aluminium, ni composés hydrosolubles de sodium ou de potassium.

9. Tôle selon la revendication 8 pour laquelle le revêtement (7) comprend en outre de l'aluminium pour une teneur en poids comprise entre 0,1 et 20%.

10. Tôle selon la revendication 8 pour laquelle le revêtement (7) comprend entre 14 et 18% en poids de magnésium, le reste étant du zinc.

11. Tôle selon l'une quelconque des revendications 8 à 10 pour laquelle le poids de couche en chlore est inférieur à 70 mg/m².

12. Tôle selon la revendication 11 pour laquelle le poids de couche en chlore est compris entre 8 et 60 mg/m².

13. Tôle selon l'une quelconque des revendications 8 à 12 pour laquelle la couche (13) présente une répartition homogène sur l'ensemble de la surface du revêtement (7).

14. Tôle selon l'une quelconque des revendications 8 à 13 pour laquelle la couche (13) ne comprend en outre aucun composé hydrosoluble de calcium.

15. Tôle selon l'une quelconque des revendications 8 à 14 pour laquelle la couche (13) ne comprend aucun composé hydrosoluble autre que de zinc et/ou de magnésium.

## Patentansprüche

1. Verfahren zur Behandlung eines Metallbands (3) im Durchlauf, aufweisend die Schritte, gemäß denen:
- man bereitstellt ein Band (3) aus Stahl, das auf wenigstens einer seiner Seiten (5) beschichtet ist mit einer Beschichtung (7), die aufweist 0,1 bis 20 Gewichts-% Magnesium, ggf. 0,1 bis 20 Gewichts-% Aluminium, wobei der Rest Zink, eventuelle Verunreinigungen, die mit dem Verfahren zusammenhängen, und ggf. ein oder mehrere zusätzliche Elemente ist, die ausgewählt sind aus Si, Sb, Pb, Ti, Ca, Mn, Sn, La, Ce, Cr, Ni, Zr und Bi, wobei der Gewichts-Anteil von jedem zusätzlichen Element kleiner als 0,3% ist,
- man auf die Beschichtung (7) aufbringt, durch einfaches in Kontakt bringen, eine wässrige Behandlungslösung, die aufweist wenigstens 0,01 mol/L Zinkchlorid und die weder Natriumchlorid noch Kaliumchlorid aufweist, wobei die Konzentration an Chlorid-Ionen Cl⁻ angepasst ist, um auf der Beschichtung (7) eine Schicht (13) basierend auf Zink-Hydroxychlorid zu bilden, mit einem Chlor-Schichtgewicht von wenigstens 1 mg/m², wobei die Schicht (13) weder Hydrozinkit noch Hydroxycarbonate gemischt mit Zink und Aluminium aufweist, wobei die Temperatur der wässrigen Lösung zwischen 20 und 60°C liegt und wobei die Kontaktzeit mit der Beschichtung zwischen 2 Sekunden und 2 Minuten liegt.

2. Verfahren gemäß Anspruch 1, aufweisend einen zusätzlichen Schritt des Trocknens nach dem Aufbringen der wässrigen Behandlungslösung.

3. Verfahren gemäß irgendeinem der Ansprüche 1 oder 2, bei welchem die wässrige Behandlungslösung ferner Mg²⁺-Ionen mit einer Konzentration von zwischen 5.10⁻⁵ und 0,25 mol/L aufweist.

4. Verfahren gemäß Anspruch 3, bei welchem die Mg²⁺-Ionen der wässrigen Lösung in Form von Magnesiumchlorid zugegeben werden.

5. Verfahren gemäß irgendeinem der Ansprüche 1 bis 4, bei welchem die wässrige Behandlungslösung kein anderes Chloridsalz als Zinkchlorid und/oder Magnesiumchlorid aufweist.

6. Verfahren zur Behandlung eines Metallbands (3) im Durchlauf, aufweisend die Schritte, gemäß denen:
- man bereitstellt ein Band (3) aus Stahl, das auf wenigstens einer seiner Seiten (5) mit einer Beschichtung (7) beschichtet ist, die aufweist 0,1 bis 20 Gewichts-% Magnesium, ggf. 0,1 bis 20 Gewichts-% Aluminium, wobei der Rest Zink, eventuelle Verunreinigungen, die mit dem Verfahren zusammenhängen, und ggf. ein oder mehrere zusätzliche Elemente ist, die ausgewählt sind aus Si, Sb, Pb, Ti, Ca, Mn, Sn, La, Ce, Cr, Ni, Zr und Bi, wobei der Gewichts-Anteil von jedem zusätzlichen Element kleiner als 0,3% ist,
- man unter anodischer Polarisation auf die Beschichtung (7) aufbringt eine wässrige Behandlungslösung mit einem pH von zwischen 7 und 10, die aufweist wenigstens 0,01 mol/L Chlorid-Ionen Cl⁻, um auf der Beschichtung (7) eine Schicht (13) basierend auf Zink-Hydroxychlorid zu bilden, mit einem Chlor-Schichtgewicht von wenigstens 1 mg/m², wobei die Schicht (13) weder Hydrozinkit noch Hydroxycarbonate gemischt mit Zink und Aluminium aufweist, wobei die Ladungsmenge zwischen 10 und 100C/dm² liegt,
- man die behandelte Oberfläche spült.

7. Verfahren gemäß Anspruch 6, aufweisend einen zusätzlichen Schritt des Trocknens nach dem Spülen.

8. Blech (1) mit einem Substrat (3) aus Stahl, das auf wenigstens einer seiner Seiten (5) mit einer Beschichtung (7) beschichtet ist, die aufweist 0,1 bis 20 Gewichts-% Magnesium, ggf. 0,1 bis 20 Gewichts-% Aluminium, wobei der Rest Zink, eventuelle Verunreinigungen, die mit dem Verfahren verbunden sind, und ggf. ein oder mehrere zusätzliche Elemente ist, die ausgewählt sind aus Si, Sb, Pb, Ti, Ca, Mn, Sn, La, Ce, Cr, Ni, Zr und Bi, wobei der Gewichts-Anteil jedes zusätzlichen Elements kleiner als 0,3% ist, wobei die Beschichtung (7) ihrerseits bedeckt ist von einer Schicht (13) basierend auf Zink-Hydroxychlorid, mit einem Chlor-Schichtgewicht von wenigstens 1 mg/m², wobei die Schicht (13) weder Hydrozinkit noch Hydroxycarbonate gemischt mit Zink und Aluminium, noch wasserlösliche Natrium- oder Kalium-Verbindungen aufweist.

9. Blech gemäß Anspruch 8, wobei die Beschichtung (7) ferner aufweist Aluminium mit einem Gewichtsanteil von zwischen 0,1 und 20%.

10. Blech gemäß Anspruch 8, wobei die Beschichtung (7) aufweist zwischen 14 und 18 Gewichts-% Magnesium, wobei der Rest Zink ist.

11. Blech gemäß irgendeinem der Ansprüche 8 bis 10, wobei das Chlor-Schichtgewicht kleiner als 70 mg/m² ist.

12. Blech gemäß Anspruch 11, wobei das Chlor-Schichtgewicht zwischen 8 und 60 mg/m² liegt.

13. Blech gemäß irgendeinem der Ansprüche 8 bis 12, wobei die Schicht (13) eine homogene Verteilung über die Gesamtheit der Fläche der Beschichtung (7) hat.

14. Blech gemäß irgendeinem der Ansprüche 8 bis 13, wobei die Schicht (13) ferner keine wasserlösliche Kalzium-Verbindung aufweist.

15. Blech gemäß irgendeinem der Ansprüche 8 bis 14, wobei die Schicht (13) keine andere wasserlösliche Verbindung als von Zink und/oder von Magnesium hat.

## Claims

1. Method for treating a moving metal strip (3), comprising the following steps:
- there is provided a steel strip (3) coated on at least one of its faces (5) with a coating (7) comprising from 0.1 to 20% by weight of magnesium, optionally from 0.1 to 20% by weight of aluminium, the remainder being zinc, any impurities linked to the method and optionally one or more additional elements selected from Si, Sb, Pb, Ti, Ca, Mn, Sn, La, Ce, Cr, Ni, Zr and Bi, the content by weight of each additional element being less than 0.3%,
- there is applied to the coating (7), by simple contacting, an aqueous treatment solution comprising at least 0.01 mol/L of zinc chloride and comprising neither sodium chloride nor potassium chloride, the concentration of chloride ions Cl⁻ being adapted to form on the coating (7) a layer (13) based on zinc hydroxychloride having a chlorine layer weight of at least 1 mg/m², the layer (13) comprising neither hydrozincite nor mixed hydroxycarbonates of zinc and aluminium; the temperature of the aqueous solution being between 20 and 60°C and the contact time with the coating being between 2 seconds and 2 minutes.

2. Method according to claim 1, comprising an additional drying step subsequent to the application of the aqueous treatment solution.

3. Method according to either claim 1 or claim 2, wherein the aqueous treatment solution further comprises Mg²⁺ ions in a concentration between 5.10⁻⁵ and 0.25 mol/L.

4. Method according to claim 3, wherein the Mg²⁺ ions are added to the aqueous solution in the form of magnesium chloride.

5. Method according to any one of claims 1 to 4, wherein the aqueous treatment solution comprises no chloride salt other than zinc chloride and/or magnesium chloride.

6. Method for treating a moving metal strip (3), comprising the following steps:
- there is provided a steel strip (3) coated on at least one of its faces (5) with a coating (7) comprising from 0.1 to 20% by weight of magnesium, optionally from 0.1 to 20% by weight of aluminium, the remainder being zinc, any impurities linked to the method and optionally one or more additional elements selected from Si, Sb, Pb, Ti, Ca, Mn, Sn, La, Ce, Cr, Ni, Zr and Bi, the content by weight of each additional element being less than 0.3%,
- there is applied to the coating (7), under anodic polarisation, an aqueous treatment solution having a pH between 7 and 10 and comprising at least 0.01 mol/L of chloride ions Cl⁻ so as to form on the coating (7) a layer (13) based on zinc hydroxychloride having a chlorine layer weight of at least 1 mg/m², the layer (13) comprising neither hydrozincite nor mixed hydroxycarbonates of zinc and aluminium, said quantity of charge being between 10 and 100 C/dm²,
- the treated surface is rinsed.

7. Method according to claim 6, comprising an additional drying step subsequent to the rinsing.

8. Metal sheet (1) comprising a steel substrate (3) coated on at least one of its faces (5) with a coating (7) comprising from 0.1 to 20% by weight of magnesium, optionally from 0.1 to 20% by weight of aluminium, the remainder being zinc, any impurities linked to the method and optionally one or more additional elements selected from Si, Sb, Pb, Ti, Ca, Mn, Sn, La, Ce, Cr, Ni, Zr and Bi, the content by weight of each additional element being less than 0.3%, the coating (7) itself being covered with a layer (13) based on zinc hydroxychloride having a chlorine layer weight of at least 1 mg/m², the layer (13) comprising neither hydrozincite nor mixed hydroxycarbonates of zinc and aluminium nor water-soluble compounds of sodium or potassium.

9. Metal sheet according to claim 8, wherein the coating (7) further comprises aluminium in a content by weight between 0.1 and 20%.

10. Metal sheet according to claim 8, wherein the coating (7) comprises between 14 and 18% by weight of magnesium, the remainder being zinc.

11. Metal sheet according to any one of claims 8 to 10, wherein the chlorine layer weight is less than 70 mg/m².

12. Metal sheet according to claim 11, wherein the chlorine layer weight is between 8 and 60 mg/m².

13. Metal sheet according to any one of claims 8 to 12, wherein the layer (13) is distributed uniformly over the entire surface of the coating (7).

14. Metal sheet according to any one of claims 8 to 13, wherein the layer (13) further does not comprise any water-soluble calcium compound.

15. Metal sheet according to any one of claims 8 to 14, wherein the layer (13) does not comprise any water-soluble compound other than of zinc and/or of magnesium.
